Europäisches Patentamt

European Patent Office

Office européen des brevets

(19)

(11) **EP 1 439 546 A1**

(12) **EUROPEAN PATENT APPLICATION**

(43) Date of publication:
 **21.07.2004 Bulletin 2004/30**

(51) Int Cl.⁷: **G12B 21/02**, G11B 9/00,
 G02B 6/12, B81B 3/00

(21) Application number: **03000969.0**

(22) Date of filing: **16.01.2003**

| | |
|---|---|
| (84) Designated Contracting States:<br>**AT BE BG CH CY CZ DE DK EE ES FI FR GB GR HU IE IT LI LU MC NL PT SE SI SK TR**<br>Designated Extension States:<br>**AL LT LV MK RO**<br><br>(71) Applicant: **Max-Planck-Gesellschaft zur Förderung der Wissenschaften e.V.**<br>**80539 München (DE)**<br><br>(72) Inventors:<br>• **Alexe, Marin Dr.**<br>  **06120 Halle (DE)** | • Luo, Yun<br>  06124 Halle (DE)<br>• Szafraniak, Izabela<br>  06120 Halle (DE)<br>• Wehrspohn, Ralf Dr.<br>  06108 Halle (DE)<br>• Steinhart, Martin<br>  06114 Halle (DE)<br><br>(74) Representative:<br>**Manitz, Finsterwald & Partner GbR**<br>**Postfach 31 02 20**<br>**80102 München (DE)** |

(54) **A nanotube based cantilever arm, a method of operating and manufacturing a nanotube based cantilever arm, and a storage device and a photonic crystal based on an array of nanotube based cantilever arms**

(57)　The invention relates to a cantilever arm comprising at least one nanotube made from a piezoelectric material and having an inner surface, an outer surface, a first end fixed to a base and a second free end, at least one electrode provided on said inner surface and at least one electrode disposed on said outer surface such that said free end of said nanotube is deflectable by applying an electric signal to said electrodes. The invention also relates to a method of manufacturing and operating said cantilever arm. Further, the invention concerns a storage device and a tunable photonic band gap structure, both comprising an array of aforementioned cantilever arms.

FIG. 1

EP 1 439 546 A1

**Description**

This invention relates to a cantilever and to a method of operating and manufacturing such a cantilever arm. In addition, the invention is directed to a storage device comprising a storage medium on which information can be stored in the form of perturbations and an array of the aforementioned cantilever arms. The invention is also directed to a tunable photonic band gap structure comprising an array of the aforementioned cantilever arms.

In atomic force microscopy (AFM) and scanning tunnelling microscopy (STM) a sample is investigated by moving a sharp tip relative to a surface of the sample in a scanning movement and controlling the interaction of the tip with the sample surface (see e.g. C. Bai, "Scanning Tunneling Microscopy and its Application", Springer Series in Surface Sciences, Vol. 32, ISBN 3-540-65715-0).

In the STM case, the Z axis separation of the tip and the sample is controlled to a constant value by maintaining the tip-to-sample tunnelling current constant during a scan. The tip is disposed at the end of a cantilever and the Z-axis gap control is achieved by deflecting the cantilever and thus moving the tip relative to the sample in a precisely controlled fashion by a piezoelectric actuator.

In the AFM case, the tip is also disposed at the end of a cantilever. The Z-axis separation of the tip and the sample is controlled by maintaining a constant deflection of the cantilever as sensed by e.g. optical interferometry with corrections also being made by a piezoelectric actuator.

In STM as well as in AFM, the cantilever serves two purposes. First, it permits detection of the tip-surface interaction by allowing movement of the tip in the Z direction. Secondly, it acts as a displacement detector in combination with a detection system. This detection system is an optical system in the AFM case and a current detection system in the STM case.

However, cantilevers in known AFM and STM systems are passive components only. The actual scanning process is assigned to a macroscopic piezoelectric tube - the scanner - which moves the tip "inplane" over the sample, i.e. in XY directions, and which also adjusts the sample position in the vertical direction, i.e. the Z direction, according to a feedback signal generated by detecting the cantilever position, e.g. by a laser beam and an optical detection system, thereby measuring the topography of the sample. In addition to the above described cantilever, cantilevers are also known which are provided with position sensors based on piezoresistive thin film sensors or thin piezoelectric films placed on top of the cantilever as is disclosed in DE 195 31 466 A1 and US 6,237,399 B1.

Conventional mass storage devices are usually based on rotating storage media and read/write processes using magnetic heads. These storage devices are known as disk drives. Disk drives may have a high storage capacity in the Gbit range and a low price. However, a major drawback is a limited access time which is in the 10 ms range due to serial access of the read/write heads to the data.

Improved concepts for mass storage devices are based on local probe arrays as proposed in the US patents no. 5,307,311 and 5,835,477. The disclosed storage devices are based on an array of micro-cantilevers which is moved as a whole relative to a counterpart storage medium in a scanning movement such that each cantilever can write and read data in an associated section of the storage medium, which is called a bit array or a storage field.

It is a first object of the invention to provide a cantilever arm which can be used as a substitute for both existing cantilevers and scanners in atomic force and scanning tunnelling microscopes and which can be driven by lower voltages and has a higher sensitivity than existing piezoelectric scanners.

It is a second object of the invention to provide a method of manufacturing nanotubes for use in aforementioned cantilever arm, which also permits an easy fabrication of a highly ordered array of nanotubes.

It is a third object of the invention to provide a mass storage device based on a local probe array and ensuring a fully random read/write access with an increased access speed.

And it is a fourth object of the invention to provide a tunable photonic band gap material.

The first object is met by a cantilever arm having the features of claim 1, and in particular comprising at least one nanotube made from a piezoelectric material and having an inner surface, an outer surface, a first end fixed to a base and a second free end, at least one electrode provided on said inner surface and at least one electrode disposed on said outer surface such that said free end of said nanotube is deflectable by applying an electrical signal to said electrodes.

Since the nanotube itself is made from a piezoelectric material no additional piezoelectric coatings have to be applied to the nanotube in order to make it deflectable due to the piezoelectric effect. It is therefore possible to dispose electrically conductive material necessary to apply a potential difference to the walls of the nanotube directly on the inner surface and the outer surface of the nanotube. The cantilever arm of the invention is therefore simple in construction.

The piezoelectric effect permits a precisely controlled deflection of the nanotube since it is possible to very accurately control a voltage applied to the electrodes disposed on the surfaces of the nanotube. The other way round, it is also possible to measure externally caused deflections of the nanotube by detecting a voltage induced in the electrodes due to the piezoelectric effect. Because of the small dimensions of the nanotube, particularly the small wall thickness of the nanotube, much lower voltages are necessary to achieve a given deflection of the nanotube compared with a conventional macroscopic piezoelectric scanner tube. Also, small deflections of the nanotube generate higher voltages in the nanotube as compared with macroscopic tubes. Hence, the sensitivity of the nanotube is increased as compared to a macroscopic tube.

The cantilever arm is therefore particularly well suited for use in an atomic force microscope (AFM) or in a scanning tunnelling microscope (STM). In these applications the cantilever arm can play a dual role: First, it can act as a scanner, i.e. it can scan a certain area of a sample surface and adjust the Z axis separation of a tip disposed at an end of the nanotube and the sample surface. Secondly, the cantilever arm acts as a position detection sensor since the bending of the nanotube generates an electrical signal indicative of the deflection of the cantilever arm.

The cantilever arm of the invention further permits the provision of a storage device in which each individual storage field can be independently accessed by a read/write system. The cantilever arm of the invention also permits the construction of a tunable photonic crystal. These two application will be discussed in more detailed further below.

According to a preferred embodiment of the cantilever arm, a pair of electrodes is disposed on said outer surface of said nanotube opposite from each other. Applying a voltage to one of the opposite electrodes leads to a bending of the nanotube in one dimension. Applying a positive voltage to the one electrode and a negative voltage of equal magnitude to the other electrode results in a doubling of the scan range, i.e. of the maximum deflection, and of the sensitivity of the piezoelectric nanotube in a direction parallel to the straight line defined by the opposite electrodes.

Preferably, first and second pairs of electrodes are disposed on said outer surface of said nanotube, said pairs of electrodes being symmetrically arranged around the circumference of the nanotube. The provision of four electrodes permits the deflection of the nanotube in two dimensions. As has been explained above, the scan range and the sensitivity of the piezoelectric nanotube may be doubled by applying voltages of equal magnitude and opposite polarity to opposite electrodes.

At least one inner electrode can be a grounded connection. Thus, voltages of opposite polarity can be applied to the electrodes disposed on the outer surface of the nanotube.

Preferably said inner electrode covers substantially the complete inner surface of said nanotube. This electrode is relatively easy to fabricate since no patterning of the conductive material is necessary in the inside of the nanotube.

Preferably said electrodes extend along an axial direction of said nanotube. This ensures a uniform bending of the nanotube in the region where the electrodes are arranged.

According to a further embodiment of the cantilever arm, the nanotube has an outer diameter of about 0.5 - 5 µm, a wall thickness of about 20 - 100 nm, and a length ranging from 20 µm to 200 µm. These dimensions permit the use of the cantilever arm in atomic force and scanning tunnelling microscopes as well as in storage devices and tunable photonic crystals.

The piezoelectric material preferably is a perovskite type oxide, having the general formula $ABO_3$, wherein A and B are metallic cations and O is oxygen. This material is particularly well suited for a piezoelectric nanotube of a cantilever arm.

The invention also includes a method of operating a cantilever arm, wherein a potential difference is applied between the at least one electrode disposed on the outer surface and the at least one electrode disposed on the inner surface, thereby deflecting the nanotube in at least one dimension. The amplitude and direction of the movement can be controlled by the magnitude and sign of the potential difference applied.

The at least one electrode disposed on said inner surface is preferably grounded and a positive voltage is applied to one electrode of a pair of opposite electrodes disposed on an outer surface of the nanotube and a negative voltage of the same magnitude is applied to the other electrode of the pair of the electrodes, thereby deflecting the nanotube in one dimension. Applying voltages to only one pair of opposite electrodes drives the piezoelectric nanotube in a so-called unipolar mode, i. e. the nanotube is bend in only one dimension. The application of voltages of opposite polarity to opposite electrodes leads to a doubling of the scan range and the sensitivity of the piezoelectric nanotube.

According to another embodiment of the method, a second positive voltage is applied to one electrode of a second pair of opposite electrodes disposed on an outer surface of said nanotube and a second negative voltage of the same magnitude is applied to the outer electrode of said second pair of opposite electrodes, thereby deflecting said nanotube in two dimensions. Applying voltages to four electrodes operates the piezoelectric nanotube in a so-called bipolar mode. This permits a deflection of the nanotube in two dimensions. In addition, the application of voltages of opposite polarities to opposite electrodes of each pair of electrodes doubles the scan range and the sensitivity of the piezoelectric nanotube in both dimensions.

The second object of the invention is solved by a method of manufacturing a nanotube suitable for use as a cantilever arm, in particular as a cantilever arm of the invention, the method comprising the steps of:

> (a) bringing a precursor solution for a piezoelectric material in contact with a template comprising at least one elongate pore having an open end, such that the solution enters said open end of the pore and a film of precursor solution covers an inner wall of the pore due to surface tension;

(b) carrying out at least one heat treatment to convert said precursor solution into a nanotube of said piezoelectric material; and

(c) isolating said film as a nanotube by removing material of said template from around said nanotube.

This method is a simple and cost effective process for the fabrication of piezoelectric nanotubes. If the template comprises a plurality of pores, a plurality of nanotubes can be processed in parallel. Depending on the template, highly uniform two dimensional arrays of nanotubes on wafer scale can easily be obtained. This enables the production of high density storage devices and of tunable photonic crystals which will be described in more detail further below.

According to an embodiment of the method, said template is made from a deliberately structured or self-assembled macroporous or nanoporous material and is particularly made from macroporous silicon or micro- and nanoporous aluminium oxide. Templates of this kind are particularly well suited for the fabrication of highly uniform two dimensional arrays of piezoelectric nanotubes.

According to another embodiment, at least one electrode is formed on an inner wall of the nanotube after step (b) has been carried out and prior to carrying out step (c). By forming the inner electrode prior to removing the template, inner electrodes can be fabricated in parallel in all nanotubes present in the template.

Preferably, a solution comprising an electrically conductive material is brought into contact with said template such that the solution enters said nanotube and a film of said solution covers an inner wall of the pore due to surface tension. This infiltration process is similar to the one used for the formation of the nanotube itself.

At least one electrode can be formed on an outer surface of the nanotube after step (c) has been carried out. In this case, the outer electrode is preferably formed by a deposition technique, for example a focussed ion beam deposition technique. Deposition techniques of the kind are well understood in the art of semiconductor processing.

Alternatively, a solution comprising an electrically conductive material suitable for forming an electrode on an outer surface of the nanotube is brought in contact with said template such that the solution enters said open end of the pore and a film of said solution covers an inner wall of the pore due to surface tension prior to carrying out step (a). In this case, electrically conductive material intended to form the outer electrodes is introduced into the pore prior to introducing the material forming the piezoelectric nanotube. This represents an easy and fast way of fabricating outer electrodes on a plurality of nanotubes, since the process intrinsically takes place in parallel for all pores of the template.

The third object of the invention is met by a storage device comprising a storage medium on which information can be stored in form of perturbations, said storage medium comprising an array of independent storage fields; an array of cantilever arms, especially in accordance with the invention, said cantilever arms being disposed generally parallel to one another with their free ends confronting said array of independent storage fields, each arm being associated with a respective storage field and being adapted to effect a scanning movement relative to the associated storage field independently of the other said arms; means for reading and/or writing perturbations onto said storage medium; and means for obtaining signals from each of said probes when scanning over said perturbations.

In this storage device each cantilever arm scans its individual storage field independently of the other cantilever arms. The scanning movement of each of the cantilever arms can be separately controlled. Further, each cantilever arm has its own independent input/output circuit, such that each cantilever arm can independently read or write in its associated storage field. The separate control of each of the cantilever arms in scanning as well as in reading and writing permits a fully random access to each individual storage field of the storage medium at any time. In addition, the access to information is very fast since the individual storage fields are not read out in series, but in parallel. In principal, the entire storage medium, i.e. all of the individual storage fields, can be read out at once. The same is true for the process of writing information into the individual storage fields.

The fourth object of the invention is achieved by a tunable photonic band gap structure comprising an array of cantilever arms, especially in accordance with the invention, said cantilever arms being disposed generally parallel to one another; a semiconductor component, e.g. in the form of a column or a ball, provided at a free end of each cantilever arm such that a two dimensional photonic crystal is formed; and means for separately controlling the deflection of each of said cantilever arms such that the position and/or frequency width of a forbidden band of said photonic crystal is tuned or a waveguide is formed.

Preferred embodiments of the invention are described in the following description and in the accompanying drawings, wherein:

Fig. 1      shows a cantilever arm;

Fig. 2      shows a cross-section of a piezoelectric nanotube of the cantilever arm of Fig. 1;

Fig. 3      schematically indicates the bending of the piezoelectric nanotube of the cantilever arm of Fig. 1;

Fig. 4      shows an image obtained by scanning electron microscopy of a plurality of ferroelectric nanotubes;

Fig. 5 shows an image obtained by scanning electron microscopy of an array of piezoelectric nanotubes taken at free ends of the nanotubes;

Fig. 6 shows a storage device based on an array of cantilever arms;

Fig. 7 shows a circuit for driving a single cantilever arm in the storage device of Fig. 6; and

Fig. 8 shows a tunable photonic band gap material based on an array of cantilever arms.

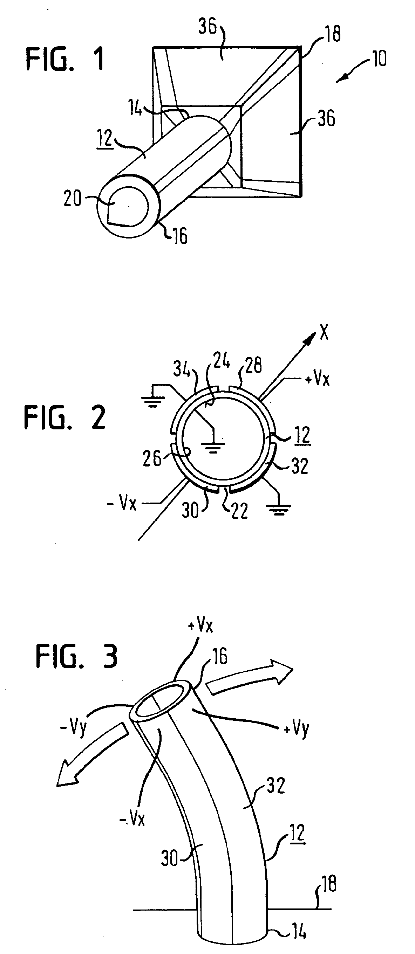

Fig. 1 shows a cantilever arm 10 comprising a nanotube 12 having a first end 14 and a second end 16. The first end 14 is fixed to a base 18 and the second end of the nanotube 12 is a free end. The nanotube 12 may, in a preferred example, have an outer diameter of about 0.05 - 5 $\mu$m, a wall thickness of about 10 - 500 nm, and a length ranging from 2 $\mu$m to 200 $\mu$m.

The nanotube 12 is made from a piezoelectric material which, in the embodiment shown, is a perovskite type oxide having the general formula $ABO_3$, wherein A and B are metallic cations and O is oxygen. Preferably, the piezoelectric material is selected from the group comprising lead zirconate titanate (PZT), barium titanate, lead titanate, lead meta-niobate, lithium niobate, lithium tantalate, bismuth germanium oxide, or any solid solution of these materials. The piezoelectric material can also be a polymer, for instance polyvinilidene fluoride, or a polymer compound thereof.

In the embodiment shown in Fig. 1, the nanotube 12 is provided with a sharp tip 20 at its free end 16. In this configuration, the cantilever arm 10 can for example be used as a cantilever for an atomic force microscope or a scanning tunnelling microscope. The tip 20 can, for instance, be formed by attaching a carbon nanotube to the free end 16 of nanotube 12 or by forming a diamond-like carbon tip by focused ion beam deposition at the free end 16 of nanotube 12. Both methods are used for the manufacture of commercially available AFM tips.

As is illustrated in Figs. 2 and 3, the nanotube 12 has an outer surface 22 and an inner surface 24. An inner electrode 26 is disposed on the inner surface 24 of the nanotube 12. The inner electrode 26 covers substantially the entire inner surface 24 of the nanotube 12. Four outer electrodes 28 - 34 are disposed on the outer surface 22 of the nanotube 12. The outer electrodes 28 - 34 are symmetrically arranged around the circumference of the nanotube 12 such that two pairs of opposite electrodes 28, 30 and 32, 34 are formed. The inner electrode 26 and the outer electrodes 28 - 34 extend substantially along the entire length of the nanotube 12. At the fixed end 14 of the nanotube 12 each one of the electrodes 26 to 34 is connected with a respective lead 36 provided on the base 18.

Via the leads 36 a voltage can be applied to each one of the electrodes 26-34. The inner electrode 26 is grounded. In order to obtain a deflection of the piezoelectric nanotube 12, either a positive or a negative voltage can be applied between at least one of the outer electrodes 28-34 and the inner electrode 26.

Applying a positive voltage $+V_x$ to one electrode 28 of one of the pairs of electrodes and a negative voltage $-V_x$ of the same magnitude to the opposite electrode 30 of the same pair of electrodes deflects the nanotube 12 in one dimension, in the X direction in the embodiment shown in Fig. 2. The other pair of opposite electrodes 32, 34 is grounded. This mode of operation is called the unipolar mode since the nanotube 12 is deflected only in one dimension.

Applying voltages of opposite polarities to the electrodes 28, 30 of one pair of opposite electrodes results in a doubling of the scan range, i.e. the deflection of the nanotube 12, as compared to a bending of the nanotube due to a voltage that is applied to only one electrode, since the nanotube is "pushed" at the one electrode and "pulled" at the other electrode. The other way round, if the voltage induced in opposite electrodes is detected in the case of a deflection of the nanotube due to an external force, the sensitivity of the nanotube 12 is doubled.

Fig. 3 shows a situation, in which voltages are applied to all four outer electrodes 28-34. Similar to the situation shown in Fig. 2, a positive voltage $+V_x$ is applied to the one electrode 28 of the first pair of opposite electrodes and a negative voltage $-V_x$ of the same magnitude is applied to the other electrode 30 of the first pair of opposite electrodes. At the same time a positive voltage +Vy is applied to the one electrode 32 of the second pair of opposite electrodes and a negative voltage -Vy of the same magnitude is applied to the other electrode 34 of the second pair of opposite electrodes.

This mode of operating the nanotube by applying voltages to all four electrodes 28-34 is called the bipolar mode. In this bipolar mode it is possible to deflect the nanotube 12 in two dimensions, i.e. in the XY directions. Such a two dimensional deflection of the nanotube 12 permits a scanning movement of the tip 20 at the free end 16 of the nanotube 12 over a sample surface extending in two dimensions.

A third mode of operating the nanotube includes simultaneously applying the same voltage or an off-set voltage to all four electrodes 28-34. In this mode the tube will longitudinally contract or expand allowing deflection in the Z direction.

By applying a bipolar signal between the inner electrode and a respective outer electrode the deflection of a piezoelectric tube measured at its free end is given by the equation:

$$\Delta x = 2 \, \frac{\sqrt{2} \, d_{31} \, V L^2}{\pi D h}$$

wherein V is the applied voltage, D is the diameter of the tube, L is the length of the tube, h is the wall thickness of the tube, and $d_{31}$ is the piezoelectric coefficient, usually expressed in Å/V. Typical values of $d_{31}$ for bulk materials range from 1.2 Å/V to -3 Å/V depending on the type of piezoelectric material. The sensitivity of a piezoelectric tube may be found by dividing both sides of the equation by V.

A conventional macroscopic scanning tube, for instance for use in an AFM or STM, typically has a diameter of 6 mm, a wall thickness of 0.6 mm, and a length of 25 mm. The piezoelectric material of this conventional tube has a $d_{31}$ value of approximately -1.75 Å/V. Thus, the calculated sensitivity of a conventional scanning piezoelectric tube is approximately 242.5 Å/V.

For scanner-type actuators a geometrical figure of merit or aspect ratio can be defined as follows:

$$k = \frac{L^2}{Dh}.$$

For macroscopic tubes with the aforementioned dimensions k has values of about 70.

In contrast, for nanotubes 12 with a typical length of 140 µm length, diameter of 1 µm and wall thickness of 0.020 µm, the aspect ratio is about 7000, in other words 100 times larger than in the macroscopic case. This also results in a sensitivity of the nanotube 12 which is 100 times larger (25000 Å/V or 2.5 µm/V).

This means, that if for a conventional macroscopic scanner 100 V is needed to obtain a scan amplitude of 1 µm, the same amplitude can be obtained with voltages well below 1 V with a nanotube 12 as shown in Fig. 1. This makes the cantilever arm 10 compatible with CMOS driving circuits.

A movement of the free end 16 of the nanotube 12 along the axis of the nanotube 12, i.e. in the Z direction, can be obtained by simultaneously applying the same voltage to all outer electrodes 28-34. The elongation of a piezoelectric tube is then given by the formula:

$$\Delta L = d_{31} V \frac{L}{h}.$$

This formula shows, that the movement in Z direction depends only on the length L of the tube and on the wall thickness h. However, it does not depend on the radius of the tube. The thinner the walls of the tube are, the greater the elongation will be. Referring to the values mentioned above, a conventional macroscopic tube will move with 5 nm/V, whereas the nanotube 12 moves with 600 nm/V.

In the embodiment of the cantilever arm shown in Fig. 2 and 3, the inner electrode 26 is grounded and the voltages $\pm V_x$ and $\pm V_y$ are applied to the outer electrodes 28-34, respectively. However, it is in principle also possible to have a grounded electrode on the outer surface 22 of the nanotube 12, in particular a grounded electrode covering the entire outer surface 22 of the nanotube 12, and four separate electrodes disposed on the inner surface 24 of the nanotube 12 to which respective voltages can be applied.

The nanotubes 12 for use in the cantilever arm 10 are fabricated by infiltrating a precursor solution into an ordered porous template having a plurality of elongate pores extending generally parallel to one another and preferably arranged in a highly ordered array. The template can be made from any fabricated or self-assembled macroporous or nanoporous material. Suitable templates are for example macroporous silicon or micro- and nanoporous aluminium oxide wafers. A method for manufacturing a self-organized array of generally parallel nanopores in alumina bulk material is disclosed in the copending German patent application 10207952.8 filed on February 25, 2002, the content of which is incorporated herein by reference.

The precursor solution can be an organic or inorganic solution comprising the necessary amount of metal cations to provide a final correct stoichiometry of the piezoelectric material of the nanotube 12, for instance a perovskite type oxide with the general formula $ABO_3$ wherein A and B are metallic cations and O is oxygen. The precursor solution should also have suitable solution properties such as viscosity, surface tension, and wetability in order to form a thin film of precursor solution on the wall of the porous of the template.

In a first step of manufacturing the nanotubes 12, the template and the precursor solution are brought into contact with each other, such that the solution enters an open end of the pores and a film of precursor solution covers an inner wall of the pores due to surface tension. The infiltration of the pores by the solution and the formation of the thin film covering the wall of the pores are controlled by the temperature of the template and of the solution, by the viscosity of the solution, by the type of the ambient gas and its partial pressure.

This infiltration process of covering an inner wall of a pore with a thin film of a solution has already been described for polymer materials by N. Steinhart et al. in Science 296, 1997 (2002) and in the copending German patent application 10210626.6, the content of which is incorporated herein by reference. It will be appreciated that the methods described in German patent application 10210626.6 can be employed to manufacture piezoelectric nanotubes in accordance with the present teaching.

The thin film of the precursor solution formed on the wall of the pores has a gel-like constituency. After removing the excess precursor solution from a surface of the template, the thin film on the pore walls is then transformed into amorphous oxide phase by a first heat treatment step at moderate temperatures ranging from 300°C to 400°C in an oxygen-rich atmosphere. The thickness of the resulting oxide layers and, hence, ultimately the thickness of the nanotube 12 can be increased by repeating the infiltration and heat treatment steps.

Finally, the amorphous oxide is transformed into a ferroelectric phase by a second heat treatment step at high temperatures. This second heat treatment step serves as a crystallisation step. Depending on the piezoelectric material used, the crystallisation heat treatment can either be done by conventional thermal annealing or rapid thermal annealing with annealing temperatures ranging from 500°C to 850°C in an oxygenrich atmosphere with annealing times ranging from 10 s to 1 hour.

As a result of the first and second heat treatment steps the thin film of precursor solution on the inner walls of the pores is converted to nanotubes 12 formed from a piezoelectric material.

The piezoelectric nanotubes are then isolated by removing material of the template from around the nanotubes 12. This can be done by etching the surrounding templates either in an etching solution for the template which provides a high etching selectivity between the template and the piezoelectric nanotube material, for instance 20 % KOH for silicon, or by using a suitable dry etching process which insures a high etching selectivity. As a result, the plurality of nanotubes 12 is obtained.

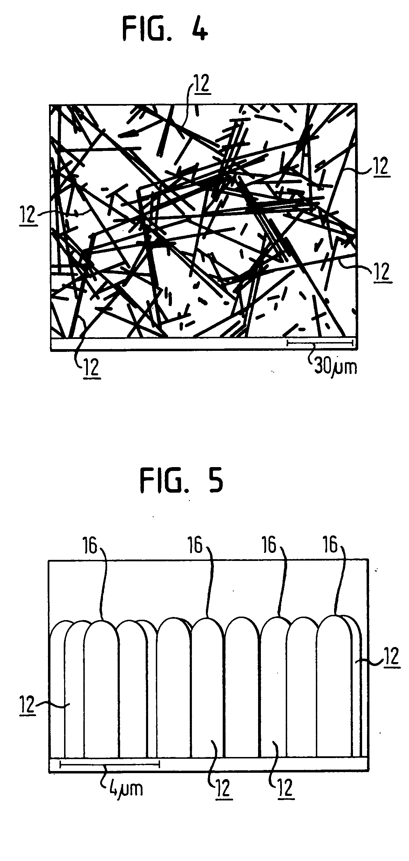

If the single nanotubes 12 are not connected to one another, they are present in a disorganised assembly of individual nanotubes 12, as is shown in Fig. 4.

However, it is also possible to connect a plurality or all of the nanotubes 12 to a common base. Preferably, the base is fixed to the ends of the nanotubes 12 at the opening of the pores before the template is removed. In this case, an array of nanotubes 12 with their first ends 14 fixed to a common base 18 is obtained. Depending on the arrangement and the form of the pores and the template, a highly ordered array of substantially parallel nanotubes 12 can thus be fabricated. Fig. 5 shows the free ends 16 of a plurality of nanotubes 12 which are fixed to a common base 18 in such an array of nanotubes 12.

The inner electrodes 26 which can be made from a perovskite type of material, such as e.g. $SrTiO_3$: La, $SrRuO_3$, $La(Sr,Co)O_3$, $LaNiO_3$ and similar conductive materials, or which can be simple metal electrodes are disposed on the inner surface 24 before the template is removed and after the nanotubes 12 have been formed by using an infiltration method similar to the one used to fabricate the nanotubes 12 from the precursor solution. To this end a solution comprising an electrically conductive material is brought in contact with the template such that the solution enters the nanotubes 12 and a film of said solution covers the inner surface of the nanotubes.

The outer electrodes 28-34 can comprise platinum, palladium, metallic oxides, or any other suitable metallic material and can be deposited either before infiltration of the precursor solution for the nanotubes 12 or after removing of the template.

If the outer electrodes 28-34 are formed after the removal of the template, any appropriate deposition method, for instance a focus ion beam deposition technique for the deposition of Pt, can be used to form outer electrodes 28-34 on the outer surfaces of single nanotubes 12.

However, if outer electrodes 28-34 are to be disposed on the outer surfaces 22 of nanotubes 12 of an array of nanotubes 12, it is preferred to deposit a suitable electrically conductive material on the walls of the pores in the template before the precursor solution for the nanotubes 12 is infiltrated into the pores, i.e. prior to the formation of nanotubes 12. To this end, a solution comprising an electrically conductive material suitable for forming an electrode on an outer wall of a nanotube 12 is brought in contact with the template such that the solution enters the open ends of the pores and a film of the solution covers an inner wall of the pores due to surface tension. This infiltration method is similar to the infiltration method used for fabricating the nanotubes 12.

Alternatively, an electrochemical deposition method may be used to deposit a suitable electrically conductive material preferentially on (110)-oriented surfaces of the inside walls of the pores in a silicon template. This method permits the formation of four separate electrodes inside the pores before the precursor solution for the nanotubes 12 is infiltrated into the pores.

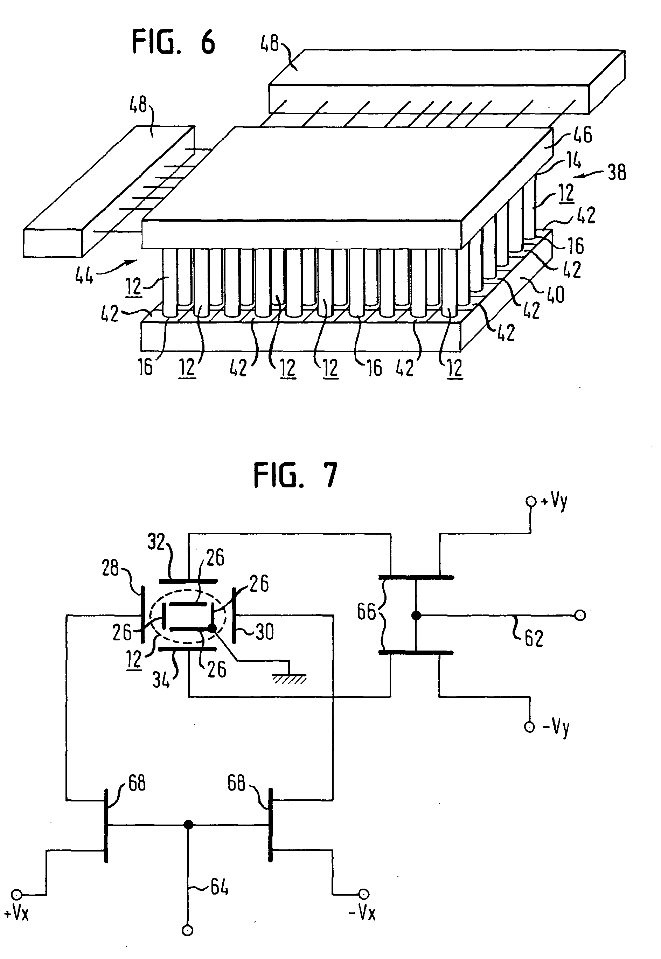

Fig. 6 shows a storage device 38 comprising a storage medium 40 on which information can be stored in the form of perturbations. The perturbations can consist of alterations on or in the surface of the storage medium 40. Suitable perturbations can for instance be the creation or alteration of the topography, of a chemical state, of an electrical state, of a polarisation state or of a magnetization state. The storage medium 40 is subdivided into a two dimensional array of individual and independent storage fields 42.

The storage device 38 further comprises a highly uniform two dimensional array 44 of nanotubes 12. The individual nanotubes 12 are fixed to a common base 46 at their first ends 14 and are generally parallel to one another with their free ends 16 confronting said array of independent storage fields 42. Each nanotube 12 is associated with a respective storage field 42 and can effect a scanning movement relative to the associated storage field 42, if positive and negative voltages are applied to the electrodes disposed on the surfaces of each nanotube 12, as has been explained with reference to Figs. 1 to 3.

In the embodiment shown in Fig. 6, the common base 46 is formed by a silicon substrate. A suitable reading and/or writing head is provided at the free end 16 of each nanotube 12. This reading and/or writing head can for example be a sharp tip 20, as is shown in Fig. 1.

In order to provide an array 44 of nanotubes 12 with sharp tips 20, inverted pyramids can be formed in a (100)-oriented monocrystalline silicon substrate by dry or wet chemical anisotropic etching. A tip layer comprising a material suitable for the tip 20, e.g. a metal or a non-metallic material such as silicon oxide or silicon nitride, may then be disposed on the silicon substrate such that a structure inverse to the inverted pyramids is formed at the side of the tip layer adjacent to the substrate, in other words pyramids are formed on a front side of the tip layer.

The array 44 of nanotubes 12 may then be attached to the rear side of the tip layer, e.g. by a bonding process, such that the free end 16 of each nanotube 12 is positioned at the base of an associated pyramid. The nanotubes 12 can either be directly attached to the tip layer or an additional layer may be disposed between the nanotubes and the tip layer.

Finally, the silicon substrate is removed, e.g. by etching the silicon in an etching solution for the silicon which provides a high etching selectivity between the silicon and the tip layer material so that the silicon is removed but not the tip layer. Alternatively, a suitable dry etching process can be used which insures such a high etching selectivity. As a result, a plurality of nanotubes 12 each having a tip formed as a pyramid at its free end 16 is obtained.

It is possible to attach the nanotubes 12 to the tip layer before the nanotubes 12 have been isolated, e.g. in the manner described above. If the silicon substrate and the template are both made from silicon, then the isolation of piezoelectric nanotubes 12 and the removal of the silicon substrate can be performed in one etching step.

The storage device 38 can for example be operated as an AFM / STM writing/reading system. The storage device shown in Fig. 6 is therefore somewhat similar to the systems described in US patents no. 5,307,311 and 5,835,477.

In contrast to these prior art systems, however, the storage device 38 shown in Fig. 6 has the great advantage of absence of any moving part. Especially, the common base 46 is in a fixed position relative to the storage medium 40. Only the nanotubes 12 will be separately deflected. In other words, each nanotube 12 will scan its associated storage field 42 independently of the other nanotubes 12.

In order to read and write information in each individual storage field 42 each nanotube is provided with an individual and independent deflection circuit and information input/ output circuit. The scanning movement and the reading/writing operation of each nanotube 12 are controlled by an electronic driving and detection circuit 48.

Fig. 7 shows a possible circuit for driving a single nanotube 12 (shown as a dotted line) of an array 44 of nanotubes 12, as is illustrated in Fig. 6. The nanotube 12 is addressed via a word line 62 and a bit line 64, as in a known RAM memory. Via word line 62 a pair of CMOS transistors 66 are controlled such that electrodes 32, 34 can be connected with a voltage source for deflecting the nanotube 12 in Y direction. Via bit line 64 a pair of CMOS transistors 68 are controlled such that electrodes 28, 30 can be connected with a voltage source for deflecting the nanotube 12 in X direction. The switching of the pairs of CMOS transistors 66, 68 is controlled by two addressing transistors (not shown), one connected with the word line 62 and the other with the bit line 64.

With this circuit, there are at least four connections to each nanotube 12 in an array 44: word line 62 and bit line 64 for addressing a particular nanotube, a line for providing a voltage which causes a deflection of the nanotube 12 in X direction, and a line for providing a voltage for causing deflection of the nanotube 12 in Y direction.

Depending on the reading/writing process one or more connections can additionally connect the sensor tip 20 (Fig. 1) at the free end 16 of the nanotube 12 to a detection circuit. For instance, in the case of reading and writing operations based on tunneling, an additional connection may be present for providing a potential difference between the tip 20 and the storage medium 40 and for measuring the tunneling current. If, on the other hand, the tip 20 is grounded and a potential difference is applied via the storage medium 40 and the tunneling current is measured via the storage medium 40, then no additional connection to the nanotube 12 is required. If the reading/writing process is based on obtaining topographic information, e.g. by elongating the nanotube until it contacts the surface of the storage medium 40, then again no additional connection is necessary.

The writing process can be based on locally altering the surface of the storage medium 40, for example by creating or altering the topographic features or composition of the surface, by altering the crystalline phase, by creating or destructing electronic states, by filling or emptying existing electronic states, by creating or altering domain structures or polarization states, or by creating or altering chemical bonds. Accordingly, the reading process can be based on detecting such perturbations.

By simultaneously addressing all the nanotubes 12 of the array 44 it is possible to scan and read/write all storage fields 42 of the storage medium 40 at the same time. However, it is also possible to address one or more specific nanotubes 12 at a time. Thus the storage device 38 ensures a fully random access with very high access speed. The resonant frequency of a cantilever arm depends roughly on the diameter and the length of the nanotube 12 and can reach about 10 MHz for nanotubes 12 having a diameter of 2 μm and a length of 10 μm.

Each storage field 42 can have an individual area of about 1 μm x 1 μm. The information can be written with a spatial resolution of about 10 nm which results in an information density of 100 x 100 bit/ nanotube (10 kb). The density of the nanotubes 12 can easily be about 1000 tubes/mm in one dimension and, hence, about $10^6$ tubes/ mm$^2$ in two dimensions. This results in an information density, i.e. storage or memory density, of 10 Gbit/ mm$^2$ or 6.5 Tbit/ in$^2$. If the spatial resolution is decreased to 10 Å, the memory density increases to an astonishing value of 1 Mbit/ storage field and a total density of $10^{12}$ mm$^{-2}$ or 650 Tbit/ in$^2$.

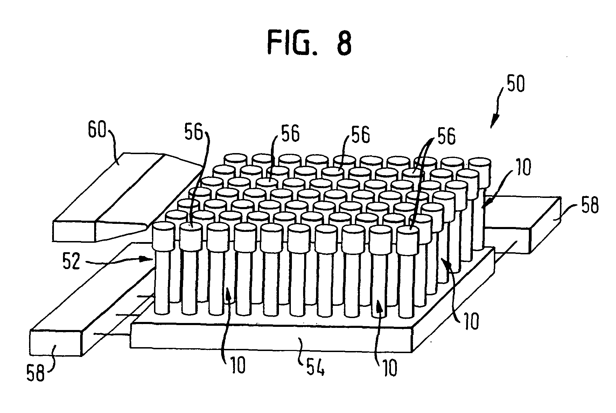

Fig. 8 shows a tunable photonic band gap material (PGB) 50 formed by a highly ordered two dimensional array 52 of cantilever arms. Each cantilever arm comprises a nanotube 12. The nanotubes 12 are arranged generally parallel to one another and are fixed to a common base 54 at their first ends 14.

A semiconductor component 56 is disposed at the free end 16 of each nanotube 12. In the embodiment shown, the semiconductor component 56 has the form of a column. However, it may also be formed as a ball, a cone or the like.

Since the nanotubes 12 are arranged in a highly uniform two dimensional array, a two dimensional photonic crystal is formed by the periodic arrangement of semiconductor components 56. The dispersion relation of this photonic crystal may have a forbidden band gap, in which no electromagnetic wave is allowed to propagate. In other words, a photonic band gap material (PGP) is formed due to the periodicity of the array of semiconductor components 56.

The periodicity of the rows and/or columns of the array of semiconductor components 56 as well as the positions of individual semiconductor components 56 can be modified by individually controlling the deflection of each underlying nanotube 12 via a multiplexing circuit 58. The periodicity, the symmetry or the radius of each region of the semiconductor photonic crystal can be modified by the behaviour of the respective ferroelectric nanotubes 12.

If the two dimensional photonic band gap crystal is exposed to a shearing force, a shear strain of about 2 % to 3 % can tune 52 % to 73 % of the original undistorted absolute band gap, as is known from S. Kim and V. Gopalan in Appl. Phys. Lett. 78, 3015 (2001). Hence, by modifying the configuration of the array 52 of the piezoelectric nanotubes 12, the width and/or position of the band gap of the overlying photonic crystal formed by the array of semiconductor components 56 are/is tuned as the symmetry of the structure is lowered.

The tuning effect is even more pronounced, if the strain force is applied to the photonic crystal such that a line defect is created which forms a wave guide. It is estimated in accordance with the present teaching that a shearing force of about 2 % to 3 % can strongly modify the propagating properties of the wave guide. This could be used to tune the wave guide from high efficiency to low efficiency.

A tunable photonic crystals or wave guide of the above-mentioned kind can, for example, be operated as switch or a filter for incoming light 60.

List of references

| 10 | cantilever arm |
| 12 | nanotube |
| 14 | first fixed end |
| 16 | second free end |
| 18 | base |
| 20 | tip |
| 22 | outer surface |
| 24 | inner surface |
| 26 | inner electrode |
| 28 | outer electrode |
| 30 | outer electrode |
| 32 | outer electrode |
| 34 | outer electrode |
| 36 | leads |
| 38 | storage device |
| 40 | storage medium |
| 42 | storage field |
| 44 | array |
| 46 | common base |
| 48 | driving and detection circuit |
| 50 | photonic band gap material |
| 52 | array |
| 54 | common base |
| 56 | semiconductor component |
| 58 | multiplexing circuit |
| 60 | incoming light |
| 62 | word line |
| 64 | bit line |
| 66 | transistor |
| 68 | transistor |

**Claims**

1. A cantilever arm (10) comprising at least one nanotube (12) made from a piezoelectric material and having an inner surface (24), an outer surface (22), a first end (14) fixed to a base (18) and a second free end (16), at least one electrode (26) provided on said inner surface (24) and at least one electrode (28-34) disposed on said outer surface (22) such that said free end (16) of said nanotube (12) is deflectable by applying an electrical signal to said electrodes (28-34).

2. A cantilever arm (10) in accordance with claim 1, wherein a pair of electrodes (28, 30) is disposed on said outer surface (22) of said nanotube (12), said electrodes being provided on opposite sides of said outer surface (22).

3. A cantilever arm in accordance with claim 1 or 2, wherein first and second pairs of electrodes (28-34) are disposed on said outer surface (22) of said nanotube (12), said pairs of electrodes (28-34) being symmetrically arranged around the circumference of said nanotube (12).

4. A cantilever arm (10) in accordance with any one of claims 1 to 3, wherein said at least one inner electrode (26) is grounded.

5. A cantilever arm in accordance with claim 4, wherein said inner electrode (26) covers substantially the complete inner surface (24) of said nanotube (12).

6. A cantilever arm (10) in accordance with any one of the preceding claims, wherein said electrodes (26-34) extend along an axial direction of said nanotube (12).

7. A cantilever arm (10) in accordance with any one of the preceding claims, wherein said nanotube (12) has an outer diameter of about 0.05 - 5 µm, a wall thickness of about 10 - 500 nm, and a length ranging from 2 µm to 200 µm.

8. A cantilever arm (10) in accordance with any one of the preceding claims, wherein said piezoelectric material is a perovskite type oxide having the general formula $ABO_3$, wherein A and B are metallic cations and O is oxygen.

9. A cantilever arm (10) in accordance with any one of the preceding claims, wherein said piezoelectric material is one of the group comprising lead zirconate titanate (PZT), barium titanate, lead meta-niobate, lithium niobate, lithium tantalate, bismuth germanium oxide, any solid solution of the aforementioned materials, a polymer, e.g. polyvinilidene fluoride, and polymer compounds thereof.

10. A cantilever arm (10) in accordance with any one of the preceding claims, wherein an electrode (28-34) disposed on said outer surface of the nanotube comprises a metallic material, e.g. platinum or palladium, or a metallic oxide.

11. A cantilever in accordance with any one of the preceding claims, wherein an electrode (26) disposed on an inner surface (24) of the nanotube comprises a perovskite type material, e.g. $SrTiO_3$:La, $SrRuO_3$, $La(Sr,Co)O_3$, and $LaNiO_3$, or a metal.

12. A method of operating a cantilever arm (10) in accordance with any one of the preceding claims, wherein a potential difference is applied between said at least one electrode (28-34) disposed on said outer surface (22) and said at least one electrode (26) disposed on said inner surface (24), thereby deflecting said nanotube (12) in at least one dimension.

13. A method in accordance with claim 12, wherein said at least one electrode (26) disposed on said inner surface (24) is grounded and a positive voltage is applied to one electrode (28) of a pair of electrodes disposed respectively on opposite sides of said outer surface (22) of said nanotube (12) and a negative voltage of the same magnitude is applied to the other electrode (30) of said second pair of opposite electrodes, thereby deflecting said nanotube (12) in one dimension.

14. A method in accordance with claim 13, wherein a second positive voltage is applied to one electrode (32) of a second pair of opposite electrodes disposed on said outer surface (22) of said nanotube (12) and a second negative voltage of the same magnitude is applied to the other electrode (34) of said second pair of opposite electrodes, thereby deflecting said nanotube (12) in two dimensions.

15. A method of operating a cantilever arm (10) in accordance with claim 12, wherein said at least one electrode (26) disposed on said inner surface (24) is grounded and the same voltage is applied to all of the electrodes (28-34) disposed on the outer surface (22) of the nanotube (12), thereby elongating or contracting said nanotube (12).

16. A method of manufacturing a nanotube (12) suitable for use as a cantilever arm (10), in particular as a cantilever arm (10) in accordance with any one of the preceding claims 1 to 11, the method comprising the steps of:

   (a) bringing a precursor solution for a piezoelectric material in contact with a template comprising at least one elongate pore having an open end such that the solution enters said open end of the pore and a film of precursor solution covers an inner wall of the pore due to surface tension;
   (b) carrying out at least one heat treatment to convert said precursor solution into a nanotube (12) of said piezoelectric material; and
   (c) isolating said film as a nanotube (12) by removing material of said template from around said nanotube (12).

17. A method in accordance with claim 16, wherein said piezoelectric material is a perovskite type oxide having the general formula $ABO_3$, wherein A and B are metal cations and O is oxygen.

18. A method in accordance with claim 17, wherein said precursor solution is an organic or inorganic solution comprising an amount of said metal cations adapted to provide the correct stoichiometry of said piezoelectric material, and having a viscosity, surface tension, and wetability adapted to form said film of the precursor solution on said inner wall of the pore.

19. A method in accordance with any one of claims 16 to 18, wherein carrying out said heat treatment comprises performing a first heat treatment for transforming said film into an amorphous oxide phase and performing a second heat treatment for transforming said film from an amorphous oxide phase into a ferroelectric phase.

20. A method in accordance with claim 19, wherein the first heat treatment is performed at a temperature in the range from 300 °C to 400 °C in an oxygen-rich atmosphere.

21. A method in accordance with claim 19 or 20, wherein the second heat treatment is performed at a temperature in the range from 500 °C to 850 °C in an oxygen-rich atmosphere.

22. A method in accordance with any one of claims 16 to 21, wherein the template is removed by dry or wet chemical etching in a gas or an etching solution, respectively, which provides a high etching selectivity between the template and the nanotube film, e.g in 20% KOH in case of a template made from silicon.

23. A method in accordance with any one of claims 16 to 22, wherein said template is made from a deliberately structured or self-assembled macroporous or nanoporous material, and particularly made from macroporous silicon or micro- and nanoporous aluminium oxide.

24. A method in accordance with any one of claims 16 to 23, wherein at least one electrode is formed on an inner surface (24) of the nanotube (12) after step (b) has been carried out and prior to carrying out step (c).

25. A method in accordance with claim 24, wherein a solution comprising an electrically conductive material is brought in contact with said template such that the solution enters said nanotube (12) and a film of said solution covers an inner surface (24) of the nanotube (12) due to surface tension.

26. A method in accordance with any one of claims 16 to 25, wherein at least one electrode (28-34) is formed on said outer surface (22) of the nanotube (12) after step (c) has been carried out.

27. A method in accordance with claim 26, wherein the outer electrode (28-34) is formed by a deposition technique, e.g. a focused ion beam deposition technique.

28. A method in accordance with any one of claims 16 to 25, wherein a solution comprising an electrically conductive material suitable for forming an electrode (28-34) on said outer surface (22) of the nanotube (12) is brought in contact with said template such that the solution enters said open end of the pore and a film of said solution covers an inner wall of the pore due to surface tension prior to carrying out step (a).

29. A storage device (38) comprising:

    a storage medium (40) on which information can be stored in the form of perturbations, said storage medium (40) comprising an array of independent storage fields (42);
    an array of cantilever arms (10), especially in accordance with any one of the preceding claims 1 to 11, said cantilever arms (10) being disposed generally parallel to one another with their free ends (16) confronting said array of independent storage fields (42), each arm being associated with a respective storage field (42) and being adapted to effect a scanning movement relative to the associated storage field (42) together with or independently of the other said arms (10);
    means for reading and/or writing perturbations onto said storage medium (40); and
    means for obtaining signals from each of said cantilever arms (10) when scanning over said perturbations.

30. A tunable photonic band gap structure (50) comprising:

    an array (52) of cantilever arms (10), especially in accordance with any one of the preceding claims 1 to 11, said cantilever arms (10) being disposed generally parallel to one another;
    a semiconductor component (56), e.g. in the form of a column or a ball, provided at a free end (16) of each cantilever arm (10) such that a two dimensional photonic crystal is formed; and
    means for separately controlling the deflection of each of said cantilever arms (10) such that the position and/or frequency width of a forbidden band of said photonic crystal is tuned or a waveguide is formed.

FIG. 1

FIG. 2

FIG. 3

# FIG. 4

# FIG. 5

# FIG. 6

# FIG. 7

## FIG. 8

**European Patent Office**

**EUROPEAN SEARCH REPORT**

Application Number

EP 03 00 0969

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | KANDA T ET AL: "A ROD-SHAPED VIBRO TOUCH SENSOR USING PZT THIN FILM" IEEE TRANSACTIONS ON ULTRASONICS, FERROELECTRICS AND FREQUENCY CONTROL, IEEE INC. NEW.YORK, US, vol. 46, no. 4, July 1999 (1999-07), pages 875-881, XP000889383 ISSN: 0885-3010 * figures 5-7 * * paragraph [0IIB] * | 1-6, 8-10,12, 15 | G12B21/02 G11B9/00 G02B6/12 B81B3/00 |
| A | | 7,11,13, 14,16-30 | |
| X | HU W ET AL: "GROWTH OF WELL-ALIGNED CARBON NANOTUBE ARRAYS ON SILICON SUBSTRATES USING POROUS ALUMINA FILM AS A NANOTEMPLATE" APPLIED PHYSICS LETTERS, AMERICAN INSTITUTE OF PHYSICS. NEW YORK, US, vol. 79, no. 19, 5 November 2001 (2001-11-05), pages 3083-3085, XP001108164 ISSN: 0003-6951 * The whole document * | 16,22,23 | |
| | | | TECHNICAL FIELDS SEARCHED (Int.Cl.7) |
| A | | 17-21, 24-28 | G12B G11B G02B B81B |
| X | EP 0 709 835 A (HEWLETT PACKARD CO) 1 May 1996 (1996-05-01) * figures 1-6 * * column 1, line 25 - line 42 * * column 8, line 4 - column 10, line 58 * | 29 | |

-/--

The present search report has been drawn up for all claims

| Place of search | Date of completion of the search | Examiner |
|---|---|---|
| BERLIN | 19 May 2003 | Polesello, P |

**European Patent Office**

## EUROPEAN SEARCH REPORT

Application Number

EP 03 00 0969

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 1 193 216 A (DAIKEN CHEMICAL CO LTD ;NAKAYAMA YOSHIKAZU (JP)) 3 April 2002 (2002-04-03) * figures 6-8 * * paragraphs [0057]-[0061] * | 1,6,7, 10,12 | |
| A | | 2-5,8,9, 11,13-30 | |
| D,X | US 5 307 311 A (SLIWA JR JOHN W) 26 April 1994 (1994-04-26) * figures 1-3,6 * * column 8, line 34 - column 13, line 26 * | 29 | |
| A | HUBER T E ET AL: "Low contact resistance of 30 nm and 200 nm diameter Bi wire array composites" EIGHTEENTH INTERNATIONAL CONFERENCE ON THERMOELECTRICS. PROCEEDINGS, ICT'99 (CAT. NO.99TH8407), EIGHTEENTH INTERNATIONAL CONFERENCE ON THERMOELECTRICS. PROCEEDINGS, ICT'99, BALTIMORE, MD, USA, 29 AUG.-2 SEPT. 1999, pages 558-561, XP010379443 1999, Piscataway, NJ, USA, IEEE, USA ISBN: 0-7803-5451-6 * The whole document * | 16-28 | TECHNICAL FIELDS SEARCHED (Int.Cl.7) |
| D,A | STEINHART M ET AL: "POLYMER NANOTUBES BY WETTING OF ORDERED POROUS TEMPLATES" SCIENCE, AMERICAN ASSOCIATION FOR THE ADVANCEMENT OF SCIENCE,, US, vol. 296, 14 June 2002 (2002-06-14), page 1997 XP001090914 ISSN: 0036-8075 * The whole document * | 16-28 | |

-/--

The present search report has been drawn up for all claims

| Place of search | Date of completion of the search | Examiner |
|---|---|---|
| BERLIN | 19 May 2003 | Polesello, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

# EUROPEAN SEARCH REPORT

Application Number

EP 03 00 0969

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | SUNGWON KIM ET AL: "Strain-tunable photonic band gap crystals" APPLIED PHYSICS LETTERS, 14 MAY 2001, AIP, USA, vol. 78, no. 20, pages 3015-3017, XP002241637 ISSN: 0003-6951 * The whole document * | 30 | |

TECHNICAL FIELDS
SEARCHED (Int.Cl.7)

The present search report has been drawn up for all claims

| Place of search | Date of completion of the search | Examiner |
|---|---|---|
| BERLIN | 19 May 2003 | Polesello, P |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**                              EP 03 00 0969

This annex lists the patent family members relating to the patent documents cited in the above-mentioned European search report.
The members are as contained in the European Patent Office EDP file on
The European Patent Office is in no way liable for these particulars which are merely given for the purpose of information.

19-05-2003

| Patent document cited in search report | | Publication date | Patent family member(s) | | Publication date |
|---|---|---|---|---|---|
| EP 0709835 | A | 01-05-1996 | JP | 8129875 A | 21-05-1996 |
| | | | CN | 1145487 A | 19-03-1997 |
| | | | EP | 0709835 A2 | 01-05-1996 |
| | | | US | 5600137 A | 04-02-1997 |
| EP 1193216 | A | 03-04-2002 | JP | 2001252900 A | 18-09-2001 |
| | | | JP | 2002172600 A | 18-06-2002 |
| | | | EP | 1193216 A1 | 03-04-2002 |
| | | | CN | 1364141 T | 14-08-2002 |
| | | | WO | 0166460 A1 | 13-09-2001 |
| | | | US | 2002158480 A1 | 31-10-2002 |
| US 5307311 | A | 26-04-1994 | US | 5216631 A | 01-06-1993 |
| | | | JP | 4289580 A | 14-10-1992 |

EPO FORM P0459

For more details about this annex : see Official Journal of the European Patent Office, No. 12/82